# EUROPÄISCHE PATENTSCHRIFT

(11) **EP 2 850 219 B1**
(45) Veröffentlichungstag und Bekanntmachung des Hinweises auf die Patenterteilung: **06.06.2018**
(21) Anmeldenummer: 13729717.2
(22) Anmeldetag: 18.06.2013
(51) Int. Cl.: C23C 14/22, C23C 14/00, C23C 14/04, C23C 14/06, C23C 14/08, H01L 41/316, H03H 9/17, H03H 3/02

(54) **VERFAHREN ZUM HERSTELLEN EINES POLYKRISTALLINEN KERAMIKFILMS**
METHOD FOR PRODUCING A POLYCRYSTALLINE CERAMIC FILM
PROCÉDÉ PERMETTANT DE PRODUIRE UN FILM POLYCRISTALLIN EN CÉRAMIQUE

(30) Priorität: 29.06.2012 DE 102012211314
(43) Veröffentlichungstag der Anmeldung: 25.03.2015
(73) Patentinhaber: Siemens Aktiengesellschaft, 80333 München (DE)
(72) Erfinder: SCHREITER, Matthias, 81379 München (DE); WERSING, Wolfram, 83346 Bergen (DE)
(86) Internationale Anmeldenummer: PCT/EP2013/062606
(87) Internationale Veröffentlichungsnummer: WO 2014/001146

(56) Entgegenhaltungen:
- WO-A1-2006/101450
- WO-A2-2007/085549
- LINK M ET AL: "c-axis inclined ZnO films for shear-wave transducers deposited by reactive sputtering using an additional blind", JOURNAL OF VACUUM SCIENCE AND TECHNOLOGY A, Bd. 24, Nr. 2, 8. Februar 2006 (2006-02-08), Seiten 218-222, XP012090907, AVS/AIP, Melville, NY [US] ISSN: 0734-2101, DOI: 10.1116/1.2165658
- LEE Y E ET AL: "Effect of oblique sputtering on microstructural modification of ZnO thin films", JOURNAL OF VACUUM SCIENCE AND TECHNOLOGY A, Bd. 15, Nr. 3, Mai 1997 (1997-05), Seiten 1194-1199, XP055073026, AVS/AIP, Melville, NY [US] ISSN: 0734-2101, DOI: 10.1116/1.580592
- CHEN L-C ET AL: "Oblique-angle sputtered AlN nanocolumnar layer as a buffer layer in GaN-based LED", JOURNAL OF LUMINESCENCE, Bd. 131, Nr. 6, 4. März 2011 (2011-03-04), Seiten 1234-1238, XP055073034, Elsevier [NL] ISSN: 0022-2313, DOI: 10.1016/j.jlumin.2011.02.016

## Beschreibung

Die Erfindung betrifft ein Verfahren zum Herstellen eines polykristallinen Keramikfilms nach dem Oberbegriff von Patentanspruch 1.

Im Bereich der Biosensorik finden zunehmend akustische Dünnfilmresonatoren (thin film bulk acoustic resonators, FBAR) Anwendung, die bei spezifischer Bindung zu detektierender Substanzen an ihrer Oberfläche Änderungen in ihrer Resonanzfrequenz erfahren. Es handelt sich dabei um piezoelektrische Kristallschichten, die auf entsprechende Substrate, beispielsweise Si-Wafer aufgebracht sind.

Da die Detektion von Biomolekülen in der Regel in Flüssigkeiten erfolgt, ist eine besonders hohe Resonanzgüte und Empfindlichkeit notwendig. Hierzu muss der Resonator im akustischen Schermode angeregt werden.

Um eine solche Anregung zu ermöglichen, ist eine Verkippung der polaren Kristallachse zum anregenden Feld notwendig. Bei einer klassischen Resonatorstruktur, bei der das Piezoelektrikum zwischen zwei Elektrodenschichten eingeschlossen ist, muss also die polare Achse eine Komponente in der Elektrodenebene aufweisen.

Bei der Verwendung von ZnO als Dielektrikum werden bei Verkippungen von ca. 40° und ca. 90° reine Scherwellen angeregt (Foster, N.F. et al., Cadmium Sulphide and Zinc Oxide Thin-Film-Transducers, IEEE Transactions on sonics and ultrasonics, Vol. SU-15, No.1, Jan. 1968). Auch relative kleine Verkippungen von beispielsweise 15° genügen jedoch, um funktionsfähige Schermode-Resonatoren zu erhalten.

Um eine solche Verkippung der polaren Achse zu erzielen, beschreibt die DE 10 2005 014 160 A1 ein Verfahren, bei welchem das Piezoelektrikum durch reaktives Sputtern abgeschieden wird. Mittels einer Blende wird dabei eine Vorzugseinfallsrichtung der Partikel eingestellt, die den gewünschten Winkel mit einer Flächennormalen der Substratoberfläche einschließt, auf welche die Keramik abgeschieden wird.

Auch in der WO 2006/101450 A1 ist ein Verfahren zum Herstellen eines polykristallinen Films auf einer Oberfläche eines Substrats beschrieben. Hierbei wachsen die Kristalle mit einer Orientierung in Vorzugsorientierung. Um ein Wachsen in der Vorzugsorientierung insbesondere für eine Keimschicht zu fördern, kann hier eine Blende vorgesehen sein.

In der WO 2007/085549 A2 wird ein Verfahren und eine Vorrichtung zum Herstellen eines polykristallinen Keramikfilms auf einem Substrat beschrieben. Die dort vorgestellte Idee besteht darin, eine mechanische Blende in der Nähe der Substratoberfläche des Substrats zu platzieren. Durch diese Blende werden bestimmte Einfallswinkel der Keramikpartikel im Prozess abgeschattet. Ein ähnliches Verfahren wird auch von Link et al. im Journal of Vacuum Science and Technology A, Bd. 24, Nr. 2 vom 8. Februar 2006 auf den Seiten 218 - 222 beschrieben.

Lee et al. beschreibt im Journal of Vacuum Science and Technology A, Bd. 15, Nr. 3 vom Mai 1997 auf den Seiten 1194-1199 den Einfluss von schiefwinkligem Sputtern auf die Mikrostruktur dünner Filme. Auch Chen et al. widmet sich im Journal of Luminescence, Bd. 131, Nr. 6 vom 4. März 2011 auf den Seiten 1234 - 1238 diesem Thema.

In der WO 2009/137556 A2 und der US 2011/0108105 A1 werden zudem Verfahren beschrieben, bei denen auf ein Substrat jeweils gezielt eine Schicht aufgebracht wird, welche durch ihre jeweilige Struktur eine nachfolgend aufgebrachte weitere Schicht in deren Struktur direkt beeinflusst und so z.B. eine Kristallqualität der weiteren Schicht verbessern kann.

Ein Nachteil des bekannten Verfahrens liegt in der Tatsache begründet, dass hierbei der Hauptanteil des Materialstroms auf die Blende und nicht auf das Substrat abgeschieden wird. Dies führt zu niedrigen Depositionsraten und macht eine Reinigung und Neueinstellung der Anlage bereits nach wenigen Depositionsvorgängen notwendig. Dies führt zu einem hohen Zeitaufwand und hohen Kosten. Die Verwendung des Blendensystems resultiert ferner in einer geringen Reproduzierbarkeit des Depositionsergebnisses, insbesondere bezüglich der Schichthomogenität.

Der vorliegenden Erfindung liegt somit die Aufgabe zugrunde, ein Verfahren nach dem Oberbegriff von Patentanspruch 1 bereitzustellen, welches eine schnelle, kostengünstige und gut reproduzierbare Herstellung von Keramikfilmen mit verkippter polarer Achse erlaubt.

Diese Aufgabe wird durch ein Verfahren mit den Merkmalen des Patentanspruchs 1 gelöst.

Bei einem solchen Verfahren zum Herstellen eines polykristallinen Keramikfilms auf einer Oberfläche eines Substrats, wird ein Partikelstrom von Partikeln auf die Oberfläche geleitet und der Keramikfilm unter Abscheidung der Partikel auf die Oberfläche ausgebildet. Bis zum Erreichen einer ersten vorgegebenen Schichtdicke wird dabei der Partikelstrom mittels einer Blende entlang einer Vorzugsrichtung auf die Oberfläche geleitet, welche einen vorgegebenen Einfallswinkel mit einer Flächennormalen der Oberfläche einschließt. Erfindungsgemäß ist dabei vorgesehen, dass nach Erreichen der vorgegebenen Schichtdicke die Blende aus dem Partikelstrom entfernt wird und weitere Partikel bis zum Erreichen einer zweiten vorgegebenen Schichtdicke auf die Oberfläche geleitet werden.

Mit anderen Worten wird die Blende nur zur Erzeugung einer Keimschicht des keramischen Materials, also die Schicht mit der ersten vorgegebenen Schichtdicke, erzeugt, welche die gewünschte Achsorientierung aufweist. Nach Ausbildung dieser Keimschicht kann die Deposition ohne Zuhilfenahme der Blende fortgeführt werden, da die Kristalle der Keimschicht auch bei ungerichtetem Materialauftrag entlang der bereits vorgegebenen Vorzugsorientierung weiterwachsen.

Dies ermöglicht es, nach Erzeugung der Keimschicht deutlich höhere Depositionsraten zu erzielen. Durch den Verzicht auf die Verwendung von Blenden nach Erzeugung der Keimschicht wird zudem deutlich mehr vom eingesetzten keramischen Material auf dem Substrat abgeschieden und die Verschmutzung der Anlage durch auf den Blenden abgefangenes Material reduziert. Dies erhöht die Anlagenstandzeit und senkt Wartungsaufwand und Kosten.

Ferner hat es sich herausgestellt, dass mittels des erfindungsgemäßen Verfahrens deutlich homogenere Schichten prozesssicher erzeugt werden können. Insbesondere die Schichtdickenhomogenität wird verbessert, so dass die gefertigten Resonatoren eine deutlich besser definierte Resonanzfrequenz und damit auch eine erhöhte Empfindlichkeit bei der Verwendung als Biosensoren aufweisen.

Bei den auf die Oberfläche geleiteten Partikeln kann es sich einerseits um Partikel aus der gewünschten Keramik selbst handeln, andererseits können, beispielsweise durch reaktives Sputtern, Metallpartikel abgeschieden werden, die erst auf der Oberfläche mit einem Reaktivgas die gewünschte Keramik bilden.

Vorzugsweise wird der vorgegebene Einfallswinkel hierbei aus dem Bereich von 0 bis 90° und insbesondere aus dem Bereich von 10 bis 30° gewählt. Damit wird sichergestellt, dass eine hinreichende Scheranregung erfolgen kann.

Es ist ferner zweckmäßig, wenn die erste vorgegebene Schichtdicke, also die Dicke der Keimschicht, 50 bis 150 nm und vorzugsweise 100 nm beträgt. Hierdurch wird gewährleistet, dass auch beim folgenden ungerichteten Auftragen ein reproduzierbares Aufwachsen der Schicht in der durch die Keimschicht vorgegebenen Vorzugsorientierung erfolgt.

Die Gesamtschichtdicke, also die zweite vorgegebene Schichtdicke, beträgt vorzugsweise 450 bis 600 nm und vorzugsweise 540 nm. In diesem Bereich können Resonatoren mit den gewünschten Resonanzfrequenz im Bereich von 100 MHz bis 10 GHz geschaffen werden.

Als Partikel werden hierbei vorzugsweise Partikel aus ZnO und/oder AlN resp. den entsprechenden Metallen verwendet. Hierbei handelt es sich um kostengünstige Materialien, die die gewünschten piezoelektrischen Eigenschaften aufweisen und durch gängige Auftragsverfahren, beispielsweise durch Sputtern oder reaktives Sputtern, aufgebracht werden können.

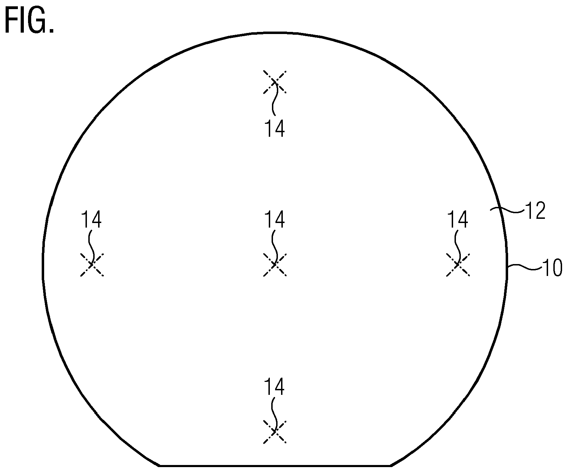

Im Folgenden werden die Erfindung und ihre Ausführungsformen anhand der Zeichnung näher beschrieben. Die einzige Figur zeigt hierbei schematisch einen Substratwafer mit mehreren Messpunkten zur Qualitätskontrolle einer mittels eines Ausführungsbeispiels eines erfindungsgemäßen Verfahrens aufgebrachten Schicht.

Zum Herstellen eines akustischen Dünnfilmresonators (FBAR) wird auf ein Substrat, beispielsweise einen Siliziumwafer 10, eine zwischen planen Elektroden eingeschlossene Schicht aus einer piezoelektrischen Keramik, beispielsweise ZnO, erzeugt. Der Auftrag der Schicht erfolgt dabei durch an sich bekannte Depositionsverfahren, wie beispielsweise das Sputtern.

Um die gewünschten Resonatoreigenschaften zu erzielen, insbesondere um die Anregung von Schermoden zu ermöglichen, muss die polare Achse des piezoelektrischen Materials einen Winkel mit der Flächennormalen des Substrats einschließen. Hierzu wird zunächst eine Keimschicht von etwa 100 nm Dicke erzeugt. Während der Deposition dieser Keimschicht wird zwischen einer Quelle für die abzuscheidenden Partikel und die Substratoberfläche 12 ein Blendensystem installiert, welches gewisse Einfallswinkel abschattet, so dass die Partikel in einer Vorzugsorientierung mit auf die gewünschte Weise verkippter polarer Achse auf die Substratoberfläche 12 abgeschieden werden.

Sobald die gewünschte Keimschichtdicke erreicht ist, kann das Blendensystem entfernt werden und die Deposition auf ungerichtete Weise fortgesetzt werden. Aufgrund der bereits erzeugten Achsorientierung in der Keimschicht erfolgt das weitere Wachstum der Schicht ebenfalls gerichtet, so dass insgesamt die gewünschte Verkippung der polaren Achse erzielt wird. Dieser Vorgang wird fortgesetzt, bis eine Gesamtschichtdicke von etwa 540 nm erreicht ist.

Während der Erzeugung der Keimschicht können Depositionsraten von etwa 4 nm/min erzielt werden, die nach Entfernen des Blendensystems auf bis zu 40 nm/min gesteigert werden können. Hierdurch wird eine deutlich beschleunigte Prozessführung im Vergleich mit aus dem Stand der Technik bekannten Verfahren erzielt, bei denen während des gesamten Depositionsvorgangs ein Blendensystem Anwendung findet.

Um die Qualität der erzeugten Schicht zu überprüfen, wurden an mehreren Messpunkten 14 eines in der FIG schematisch gezeigten 6"-Wafers Proben der Schicht analysiert und mit Proben eines mit aus dem Stand der Technik bekannten Methoden gefertigten Wafers verglichen.

Wie der Tabelle entnommen werden kann, werden mit dem Ausführungsbeispiel des erfindungsgemäßen Verfahrens deutlich homogenere Schichten erzeugt. Die Streuung der Schichtdicke, gemessen an der auf die Schichtdicke normierten Standardabweichung, verbessert sich von 10,3% auf 3%, wobei gleichzeitig die Prozessdauer von 132 min auf 34 min reduziert werden kann. Der Scherkopplungskoeffizient erfährt dabei keine nennenswerte Beeinträchtigung.

Die deutlich geringere Verweildauer der Blenden im Partikelstrom führt zudem zu einer geringeren Verschmutzung der Blenden und damit zu geringerem Reinigungs- und Nachjustieraufwand.

| | Ausführungsbeispiel der Erfindung | Stand der Technik |
|---|---|---|
| mittlere Schichtdicke [nm] | 550 | 530 |
| o(Schichtdicke)/Schichtdicke [%] | 3,0 | 10,3 |
| Scherkopplungskoeffizient [%] | 11 | 12 |
| Prozessdauer [min] | 34 | 132 |
| anteilige Verweilzeit Blende [%] | 17 | 100 |

Tab.: Vergleich wesentlicher Prozess- und Schichteigenschaften für nach dem Stand der Technik und nach einem Ausführungsbeispiel der Erfindung erzeugte Schichten

Insgesamt wird so ein Verfahren bereitgestellt, welches eine schnelle, kostengünstige und prozesssichere Herstellung von piezoelektrischen Keramikschichten mit einer vorgegebenen Achsverkippung erlaubt.

## Patentansprüche

1. Verfahren zum Herstellen eines polykristallinen Keramikfilms auf einer Oberfläche (12) eines Substrats (10), bei welchem ein Partikelstrom auf die Oberfläche (12) geleitet und der Keramikfilm unter Abscheidung der Partikel auf die Oberfläche (12) ausgebildet wird, wobei bis zum Erreichen einer ersten vorgegebenen Schichtdicke der Partikelstrom mittels einer Blende entlang einer Vorzugsrichtung auf die Oberfläche (12) geleitet wird, welche einen vorgegebenen Einfallswinkel mit einer Flächennormalen der Oberfläche (12) einschließt,
**dadurch gekennzeichnet, dass**
nach Erreichen der vorgegebenen Schichtdicke die Blende aus dem Partikelstrom entfernt wird und weitere Partikel bis zum Erreichen einer zweiten vorgegebenen Schichtdicke auf die Oberfläche (12) geleitet werden.

2. Verfahren nach Anspruch 1,
**dadurch gekennzeichnet, dass** die vorgegebene Einfallswinkel aus dem Bereich von 0 bis 90° und insbesondere aus dem Bereich von 10 bis 30° gewählt wird.

3. Verfahren nach Anspruch 1 oder 2,
**dadurch gekennzeichnet, dass** die erste vorgegebene Schichtdicke 50 bis 150 nm und vorzugsweise 100 nm beträgt.

4. Verfahren nach einem der Ansprüche 1 bis 3,
**dadurch gekennzeichnet, dass** die zweite vorgegebene Schichtdicke 450 bis 600 nm und vorzugsweise 540 nm beträgt.

5. Verfahren nach einem der Ansprüche 1 bis 4,
**dadurch gekennzeichnet, dass** als Partikel Partikel aus ZnO und/oder AlN verwendet werden.

6. Verfahren nach einem der Ansprüche 1 bis 5,
**dadurch gekennzeichnet, dass** der Partikelstrom durch Sputtern bereitgestellt wird.

## Claims

1. Method for producing a polycrystalline ceramic film on a surface (12) of a substrate (10), in which a particle stream is directed onto the surface (12) and the ceramic film is formed by deposition of the particles on the surface (12), wherein until a first specified layer thickness is reached, the particle stream is directed by means of a diaphragm in a preferred direction onto the surface (12), making a specified angle of incidence with a normal to the surface (12), **characterized in that** after attainment of the specified layer thickness, the diaphragm is removed from the particle stream and further particles are directed onto the surface (12) until a second specified layer thickness is reached.

2. Method according to Claim 1, **characterized in that** the specified angle of incidence is selected from the range from 0 to 90° and especially from the range from 10 to 30°.

3. Method according to Claim 1 or 2, **characterized in that** the first specified layer thickness is 50 to 150 nm and preferably 100 nm.

4. Method according to one of Claims 1 to 3, **characterized in that** the second specified layer thickness is 450 to 600 nm and preferably 540 nm.

5. Method according to one of Claims 1 to 4, **characterized in that** particles of ZnO and/or AlN are used as particles.

6. Method according to one of Claims 1 to 5, **characterized in that** the particle stream is provided by sputtering.

## Revendications

1. Procédé destiné à produire un film polycristallin en céramique sur une surface (12) d'un substrat (10), dans lequel un flux de particules est dirigé sur la surface (12) et le film en céramique est réalisé par dépôt des particules sur la surface (12), dans lequel jusqu'à l'obtention d'une première épaisseur de couche prédéfinie le flux de particules est dirigé vers la surface (12) au moyen d'un diaphragme le long d'une direction préférée, lequel diaphragme inclut un angle d'incidence prédéfini avec une normale de surface de la surface (12),
**caractérisé en ce que**
après avoir atteint l'épaisseur de couche prédéfinie le diaphragme est retiré du flux de particules et d'autres particules sont dirigées vers la surface (12) jusqu'à l'obtention d'une deuxième épaisseur de couche prédéfinie.

2. Procédé selon la revendication 1,
**caractérisé en ce que** l'angle d'incidence prédéfini est choisi dans la plage de 0 à 90° et en particulier dans la plage de 10 à 30°.

3. Procédé selon la revendication 1 ou 2,
**caractérisé en ce que** la première épaisseur de couche prédéfinie est de 50 à 150 nm et de préférence 100 nm.

4. Procédé selon l'une des revendications 1 à 3,
**caractérisé en ce que** la deuxième couche prédéfinie est de 450 à 600 nm et de préférence 540 nm.

5. Procédé selon l'une des revendications 1 à 4,
**caractérisé en ce que** des particules de ZnO et/ou d'AlN sont utilisées en tant que particules.

6. Procédé selon l'une des revendications 1 à 5,
**caractérisé en ce que** le flux de particules est préparé par pulvérisation.
